# EUROPÄISCHE PATENTANMELDUNG

(11) **EP 0 650 228 A2**
(43) Veröffentlichungstag der Anmeldung: **26.04.1995**
(21) Anmeldenummer: 94115814.9
(22) Anmeldetag: 07.10.1994
(51) Int. Cl.: H01R 13/639

(54) **Anordnung zum Verschliessen einer Öffnung in einem Gehäuse**

(30) Priorität: 20.10.1993 DE 9315970 U
(71) Anmelder: Mannesmann Kienzle GmbH, D-78052 Villingen-Schwenningen (DE)
(72) Erfinder: Schmid, Mechtilde, Dipl.-Ing. (FH), D-78052 Villingen-Schwenningen (DE); Koch, Siegfried, Dipl.-Ing. (FH), D-78056 Villingen-Schwenningen (DE)

(57) **Zusammenfassung**

Es wird eine Anordnung vorgeschlagen, welche für das Verschließen einer dem Einführung eines Steckers in ein Gehäuse (1) eines Gerätes dienenden Öffnung (18) vorgesehen ist.

Der an zwei sich schneidenden Wänden des Gehäuses (1) ausgebildeten Öffnung (18) ist ein als Winkelstück ausgebildetes Gehäusebauteil (17) zugeordnet. An den Wänden des Gehäuses (1) und an dem Gehäusebauteil (17) sind Falzverbindungen derart gegensinnig ausgebildet, daß eine wandbündige und selbstsichernde Montage des Gehäusebauteils (17) gegeben ist.

## Beschreibung

Die Erfindung betrifft eine Anordnung zum Verschließen einer Öffnung in einem Gehäuse, wobei die Öffnung dem Durchführen eines an einem Kabel oder einem Leitungsbündel angeordneten Steckers dient, welcher mit einem innerhalb des Gehäuses befindlichen Steckersockel kuppelbar ist.

Bei Meß- und Datenerfassungsgeräten, die in Kraftfahrzeugen eingesetzt und dort insbesondere im Sichtbereich des Fahrers angeordnet werden, ist es wegen der vielfach komplizierten Verlegung der für die Energieversorgung und die Signalübertragung erforderlichen Leitungen zweckmäßig, zwischen den betreffenden Geräten und den Leitungen bzw. einem diese zusammenfassenden Kabel, Steckverbindungen vorzusehen und auf diese Weise eine von einem anzuschließenden Gerät unabhängige Verlegung von vorkonfektionierten Leitungen zu ermöglichen. Lösungen der Art, daß ein geräteseitig vorgesehener Steckersockel unmittelbar an einer Wand eines Gerätes befestigt und somit keine Durchführung des Steckers durch die Wand erforderlich ist, sind zwar, abgesehen von einer in den meisten Fällen erforderlichen Plombierung der Steckverbindung am Einbauort schnell montierbar, sie erfordern aber einen relativ hohen geräteseitigen Aufwand für das Anbringen des Steckersockels und dessen Kontaktierung innerhalb des betreffenden Gerätes beispielsweise mit einer Leiterplatte. Außerdem erfordern Geräte mit von außen gesteckten Steckern, wenn sie eingebaut werden sollen, erheblichen Raumbedarf, was die Einbautiefe anbelangt. Andererseits bietet bei einem freistehend montierten oder an einer Fahrzeugwand "angehefteten" Gerät eine mit Steckern versehene Gerätewand einen wenig ästhetischen Anblick. Ein solches bauliches Konzept ist ferner nicht dazu geeignet, ein Gerät mit der Gerätewand, an der die Stecker angebracht werden - in der Regel ist das die der Front- bzw. Anzeigewand parallele Rückwand - an einer Fahrzeugwand am Armaturenbrett oder einem für die Geräteanbringung vorgesehenen Podest ohne weiteres anzuflanschen bzw. anzuheften.

Demgegenüber müssen bei einem Gerätekonzept, bei dem in vorteilhafter Weise der Steckersockel unmittelbar auf einer Leiterplatte des Gerätes befestigt ist und in einer Gehäusewand eine ein Durchführen eines Steckers ermöglichende Öffnung vorgesehen ist, Vorkehrungen getroffen werden, die nach dem Zusammenfügen der Steckverbindung ein Abdecken der Öffnung bis auf eine Durchführungsöffnung für die Leitungen gestatten.

Aufgabe der vorliegenden Erfindung war es somit, eine für eine Serienfertigung geeignete Anordnung zu schaffen, mit welcher eine den ästhetischen Belangen gerecht werdende wandbündige Abdeckung einer Steckerdurchführungsöffnung gemäß dem Gattungsbegriff auf einfache Weise, insbesondere auch am Einbauort eines Gerätes, vorgenommen werden kann.

Die erfindungsgemäße Lösung beschreibt der Anspruch 1. Vorteilhafte Ausgestaltungen der gefundenen Lösung gehen aus den Unteransprüchen hervor.

Der Vorteil, den die Erfindung bietet, ist, abgesehen davon, daß die gestellte Aufgabe in vollem Umfange gelöst wird, darin zu sehen, daß die Öffnung als eine zwei sich schneidenden Wänden gemeinsame Aussparung ausgebildet ist und daß zum Verschließen der Öffnung nur ein Gehäusebauteil verwendet wird, welches als Winkelstück ausgebildet ist und somit von vornherein eine größere Stabilität aufweist als ein flaches, plattenförmiges Bauteil. Andererseits bietet das Gehäusebauteil die Möglichkeit, daß an jedem Wandschenkel ausbrechbare Bereiche für das Durchführen von für den Betrieb des Gerätes erforderlichen Leitungen ausgebildet werden können. Dadurch ergibt sich eine gute Installierbarkeit des Gerätes, insbesondere eine Wahlfreiheit bezüglich des Abgangs der Leitungen, was insbesondere beim Herausführen von Kabeln durch Kabelmuffen bzw. Kabeltüllen oder bei Verwendung von Panzerkabeln von entscheidender Bedeutung ist. Vorteilhaft ist ferner, daß das Gehäusebauteil in einer Richtung montiert werden kann und daß nur eine Schraube und zwar eine ohnehin für das Zusammenfügen des Gerätegehäuses vorgesehene Schraube für das Befestigen des Bauteils erforderlich ist. Mit dem Plombieren dieser Gehäuseschraube ist gleichzeitig auch das letzten Endes den Stecker gegen Abziehen sichernde und das Kabel bzw. Leitungsbündel führende Gehäusebauteil plombiert. Wesentlich ist ferner, daß die Plombierung nach der Montage und der Funktionsprüfung des Gerätes erfolgen kann. Durch die gegensinnige Falzausbildung der Wandelemente des Gehäusebauteils ergibt sich einerseits eine gewisse während der Montage vorteilhafte Selbstsicherung, andererseits eine feste Verbindung des Wandbauteils mit dem Gehäuse, wenn lediglich das außen anliegende Wandelement verschraubt ist. Außerdem wird vermieden, daß das innen anliegende Wandelement nach außen ausweicht und absteht, wenn von einem durchgeführten Kabel ein Drehmoment auf das Wandbauteil ausgeübt wird. Die erwähnte Selbstsicherung kann durch zwischen dem Gehäuse ausbildbaren Rastverbindungsmittel sowie durch Vorsehen einer gewissen Vorspannung weiter verbessert werden.

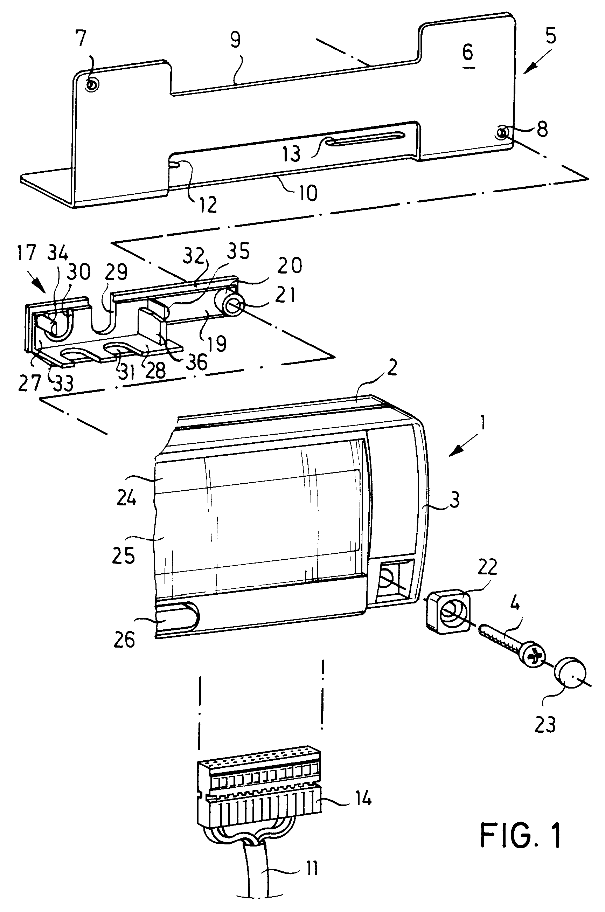

Im folgenden sei die Erfindung anhand der Zeichnungen näher erläutert:
Es zeigen Fig. 1 ein Montagebeispiel für die Anordnung eines Gerätes an einem Halter,
Fig. 2 eine perspektivische Rückansicht des Gerätes mit einer Ansicht des Gehäusebauteils,
Fig. 3 eine Seitenansicht des Gerätes mit einem Teilschnitt im Bereich der Aussparung zur Durchführung des Steckers,
Fig. 4 eine Perspektivdarstellung des Gehäusebauteils.

Wie aus Fig. 1 ersichtlich ist, besteht das Gehäuse 1 des teilweise dargestellten Gerätes beispielsweise eines Taxameters für die Fahrpreisberechnung in Mietfahrzeugen aus zwei Gehäuseschalen 2 und 3, die miteinander lösbar verbunden sind. Eine der für die Verbindung der Gehäuseschalen 2 und 3 vorgesehenen Schrauben ist mit 4 bezeichnet und dient gleichzeitig dem Befestigen des Gerätes an einem L-förmigen Halter 5, dessen einer Schenkel 6 für die Befestigung des Gerätes 1 mit Gewinden 7 und 8 versehen ist. In dem Halter 5 ausgebildete Freisparungen 9 und 10 sind für das Herausführen, des beispielsweise mittels eines Schrumpfschlauches zusammengehaltenen Leitungsbündels 11 in Richtung des Halters 5 vorgesehen. Mit 12 und 13 sind Langlöcher bezeichnet, die der Befestigung des Halters 5 dienen. Die Ausbildung des Halters 5 ist derart gewählt, daß sich das Gerät, je nachdem wie es mit dem Halter 5 verbunden ist, als Aufbaugerät oder hängend in einem Fahrzeug anordnen läßt.

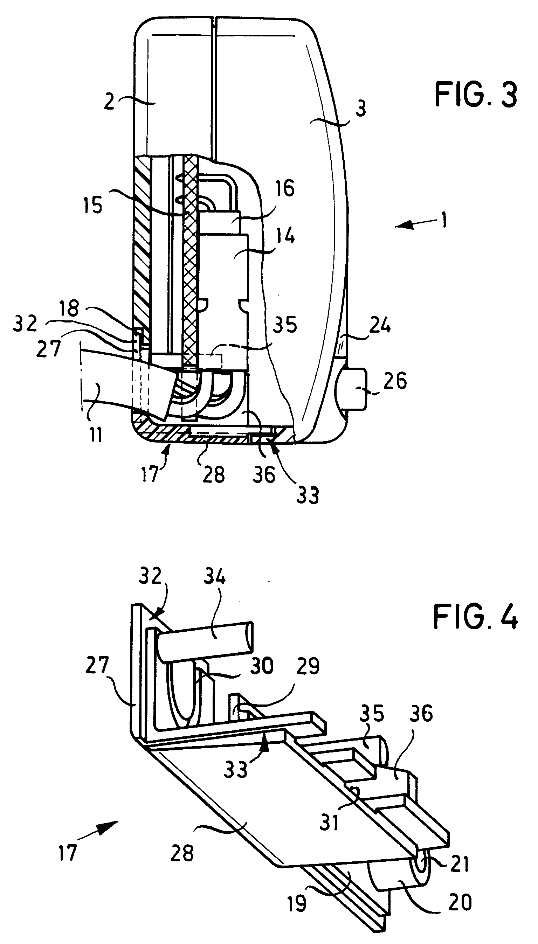

Bei der Montage des Gerätes am Einbauort wird, wenn der Halter 5 montiert ist, ein mit einem für den Betrieb des Gerätes erforderlichen Leitungsbündel 11 verbundener Stecker 14 mit einem auf einer Leiterplatte 15 kontaktierten Steckersockel 16 (Fig. 3) gekuppelt und nachfolgend eine in dem Gehäuse 1 ausgebildete und für die Steckereinführung vorgesehene Öffnung 18 mit einem im folgenden noch näher zu beschreibenden als Winkelstück geformten Wandbauteil 17 abgedeckt. Dabei ist die Fügeverbindung zwischen dem Wandbauteil 17 und den nicht näher bezeichneten Wänden des Gehäuses 1, an denen die Öffnung 18 ausgebildet ist, wenigstens insoweit bezüglich des Wandbauteils 17 selbstsichernd ausgebildet, daß das Gerät ohne das Wandbauteil 17 zusätzlich an dem Gehäuse 1 zu befestigen, an dem Halter 5 befestigt werden kann. In diesem Falle weist die an einem Arm 19 des Wandbauteils 17 ausgebildete Buchse 20 eine Durchgangsbohrung 21 zum Durchführen der Schraube 4 auf. Nach dem Anziehen der Schraube 4, welcher ein Plombennäpfchen 22 und eine Plombe 23 zugeordnet sind, ist das Wandbauteil 17 infolge einer wandbündigen Ausbildung zwischen dem Halter 5 und dem Gehäuse 1 mittelbar befestigt. Bei einer Anbringung des Gerätes als Vorbaugerät an einer flachen Wand, beispielsweise mittels einer Klettverschlußmatte, wird das Wandbauteil 17 mit dem Gehäuse 1 verschraubt. Dementsprechend ist in der Buchse 20 ein der Schraube 4 entsprechendes Gewinde ausgebildet. Der Vollständigkeit halber sei noch erwähnt, daß das dargestellte Gerät frontseitig ein durch eine Sichtscheibe 24 abgedecktes Display 25 aufweist und mit 26 eine von mehreren Tasten bezeichnet ist, mittels denen die Funktionen des Gerätes steuerbar sind.

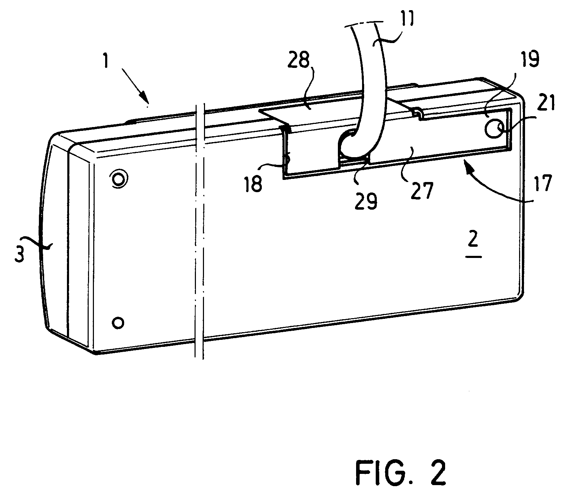

Wie aus der Fig. 2 hervorgeht, stellt das Wandbauteil 17 als Abdeckung der Öffnung 18 mit einem Wandelement 27 einen Teil der Rückwand des Gehäuses 1 und mit dem anderen Wandelement 28 einen Teil einer von beiden Gehäuseschalen 2 und 3 gemeinsam gebildeten Seitenwand dar. Bei dem gewählten Ausführungsbeispiel ist für die Durchführung des mittels des Schrumpfschlauches 11 gebildeten Kabels eine Öffnung 29 im Wandelement 27 vorgesehen. Das heißt, die Öffnung 29 ist vor der Montage des Wandbauteils 17 durch Ausbrechen eines hierfür durch eine geeignete Kerbung 30 bzw. Wandausdünnung 31 vorgesehenen Bereiches geschaffen worden.

Die Seitenansicht Fig. 3 zeigt die Funktion des Gehäusebauteils 17 als Winkelstück insofern, als die an zwei sich schneidenden Wänden des Gehäuses 1 ausgebildete, dem Einführen des Steckers 14 und wahlweise Herausführen des Leitungsbündels 11 dienende Öffnung 18 lediglich durch Aufstecken des Gehäusebauteils 17 bündig mit den Gehäusewänden, in denen die Öffnung 18 ausgespart ist, geschlossen wird. Hierzu sind an den Wandelementen 27, 28 des Gehäusebauteils 17 Falze 32 und 33 derart ausgebildet, daß sie gegensinnig wirksam sind. Das heißt, der Falz 32 des einen Wandelementes 27 weist, bezogen auf das Gehäuse 1 nach innen, der Falz 33 des anderen Wandelementes 28 nach außen.

In diesem Zusammenhang ist auch die Ausbildung eines oder mehrerer Riegel an dem Wandelement 28 sowie diesen zugeordnete, in der Gehäusewand angebrachte Aussparungen denkbar.

Mit 34 und 35 sind am Gehäusebauteil 17 ausgebildete Finger bezeichnet. Diese geben die Lage des Steckers 14 vor, da der Stecker 14, wenn als Steckersockel eine Kontaktstiftleiste verwendet wird, im Raster versetzt gesteckt sein kann. Mit anderen Worten, mittels der Finger 34 und 35 ist, weil dann das Gehäusebauteil 17 nicht einsetzbar ist, erkennbar, daß der Stecker 14 nicht ordnungsgemäß gesteckt ist. Werden in der Leiterplatte 15 den Fingern 34 und 35 entsprechende Durchbrüche vorgesehen, ergibt sich für das Wandbauteil 17 eine zusätzliche Lagesicherung. Mit einem ebenfalls an dem Gehäusebauteil 17 ausgeformten Anschlag in Form einer Rippe 36 wird erreicht, daß der Stecker 14 bezüglich der Einstecktiefe ordnungsgemäß sitzt bzw. gesetzt wird. Gleichzeitig wird, wenn das Gehäusebauteil 17 mit dem Gehäuse 1 fest verbunden ist, vermieden, daß, insbesondere bei einem geraden Abgang des Leitungsbündels 11, der Stecker 14 durch Ziehen am Leitungsbündel 11 außer Eingriff mit dem Steckersockel gebracht werden kann.

Abschließend sei noch erwähnt, daß die gefundene Lösung unter Verwendung nur eines Gehäusebauteils 17 den unterschiedlichsten Installationssituationen gerecht werden kann. Erforderliche Änderungen an dem Gehäusebauteil 17 lassen sich auf einfache Weise am Einbauort vornehmen.

## Patentansprüche

1. Anordnung zum Verschließen einer Öffnung in einem Gehäuse, wobei die Öffnung dem Durchführen eines an einem Kabel oder einem Leitungsbündel angeordneten Steckers dient, welcher mit einem innerhalb des Gehäuses befindlichen Steckersockel kuppelbar ist,
dadurch gekennzeichnet,
daß die Öffnung (18) als eine zwei sich schneidenden Wänden des Gehäuses (1) gemeinsame Aussparung ausgebildet ist, daß ein die Öffnung (18) bündig zu den Außenflächen der beiden Gehäusewände abdeckendes, als Winkelstück ausgebildetes Gehäusebauteil (17) vorgesehen ist,
daß in den Wandelementen (27, 28) des Gehäusebauteils (17) ausbrechbare Bereiche zur Durchführung des Kabels oder Leitungsbündels (11) ausgebildet sind und
daß an den Wänden des Gehäuses (1) und den Wandelementen (27, 28) des Gehäusebauteils (17) Falze (32, 33) ausgeformt sind, derart, daß die Falzverbindungen zwischen den Wänden des Gehäuses (1) und den zugehörigen Wandelementen (27, 28) des Gehäusebauteils (17) gegensinnig wirksam sind.

2. Anordnung nach Anspruch 1,
dadurch gekennzeichnet,
daß das Gehäusebauteil (17) wenigstens an einer Wand des Gehäuses (1) lösbar befestigbar ist.

3. Anordnung nach Anspruch 1,
dadurch gekennzeichnet,
daß an einem Wandelement (28) des Gehäusebauteils (17) wenigstens ein Riegel angeformt und in der mit dem Wandelement (28) in Fügeverbindung stehenden Gehäusewand eine dem Riegel zugeordnete Aussparung vorgesehen ist.

4. Anordnung nach Anspruch 1,
dadurch gekennzeichnet,
daß an einem Wandelement (27) des Gehäusebauteils (17) ein in eine Schraubverbindung des Gehäuses (1) eingreifender Arm (19) mit einer der Schraube (4) der Schraubverbindung entsprechenden Durchgangsbohrung (21) angeformt ist.

5. Anordnung nach Anspruch 4,
dadurch gekennzeichnet,
daß an dem Arm (19) eine Buchse (20) mit einer der Schraube (4) der Schraubverbindung entsprechenden Durchgangsbohrung (21) oder einem Gewinde ausgebildet sind.

6. Anordnung nach Anspruch 1,
dadurch gekennzeichnet,
daß an dem Gehäusebauteil (17) nach innen weisende Finger (34, 35) für eine seitliche und ein Anschlag (36) für eine stirnseitige Lagekontrolle des Steckers (14) ausgebildet sind.

7. Anordnung nach Anspruch 1,
dadurch gekennzeichnet,
daß das Gehäusebauteil (17) durch Verschrauben des Gehäuses (1) mit einem Halter (5) oder mit einem Fahrzeugteil an dem Gehäuse (1) dadurch mittelbar befestigt ist, daß das außen anliegende Wandelement (27) zwischen dem Halter (5) und dem Gehäuse (1) angeordnet ist.
